(19) Europäisches Patentamt
European Patent Office
Office européen des brevets

(11) EP 2 235 833 B1

(12) **EUROPEAN PATENT SPECIFICATION**

(45) Date of publication and mention
of the grant of the patent:
**08.01.2014 Bulletin 2014/02**

(51) Int Cl.:
**H03M 1/06** (2006.01)   **H03M 1/10** (2006.01)
**G01R 35/00** (2006.01)   **G01R 27/02** (2006.01)

(21) Application number: **08702640.7**

(22) Date of filing: **14.01.2008**

(86) International application number:
**PCT/IL2008/000059**

(87) International publication number:
**WO 2009/090625 (23.07.2009 Gazette 2009/30)**

(54) **METHOD AND APPARATUS FOR TESTING DATA CONVERTERS**

VERFAHREN UND VORRICHTUNG ZUM PRÜFEN VON DATENUMSETZERN

PROCEDE ET APPAREIL DE TEST DE CONVERTISSEURS DE DONNEES

(84) Designated Contracting States:
**AT BE BG CH CY CZ DE DK EE ES FI FR GB GR
HR HU IE IS IT LI LT LU LV MC MT NL NO PL PT
RO SE SI SK TR**

(43) Date of publication of application:
**06.10.2010 Bulletin 2010/40**

(73) Proprietor: **DSP Group Ltd.
46120 Herzliya (IL)**

(72) Inventor: **ITKIN, Yuval
42823 Zoran (IL)**

(74) Representative: **Giovannini, Francesca et al
Osha Liang
32, avenue de l'Opéra
75002 Paris (FR)**

(56) References cited:
**US-A- 5 381 148        US-A- 5 659 312
US-A1- 2005 157 819     US-A1- 2005 157 819
US-B1- 6 567 022        US-B1- 6 567 022**

**Description**

BACKGROUND OF THE DISCLOSURE

TECHNICAL FIELD

The present disclosure relates to testing in general, and to a method and apparatus for digitally testing a pair of converters, in particular.

DISCUSSION OF THE RELATED ART

When conducting tests of an electronic device, testing should be performed to the level of a replaceable component, i.e., if a particular component comprises two or more sub-components which are not individually fixed or replaced, it is enough to test the component as one unit, and there is no particular importance to pinning down the malfunctioning sub-component. Since testing should be performed as cheap and efficient as possible, then testing such a component as one unit, if designed correctly may save specialized equipment and separate tests and thus increase the testing efficiency.

When testing a combined converter unit comprising a Digital-to-Analog Converter (DAC) and an Analog-to-Digital Converter (ADC), if the two converters are not to be replaced or fixed separately, it is beneficial to test them together, by feeding digital data into the DAC, feeding the analog output of the DAC into the ADC, and digitally testing the digital output of the ADC. Using this scheme, it is not required to generate or test analog signals, thus saving on analog testing equipment and on testing time.

However, when testing the two converters together, even if both are functional, their characteristics indicating the output voltage vs. the input voltage may not be one-to-one, and moreover may not match each other. Thus, the output of such a unit comprising a pair of converters may deviate from the input although both components are functional.

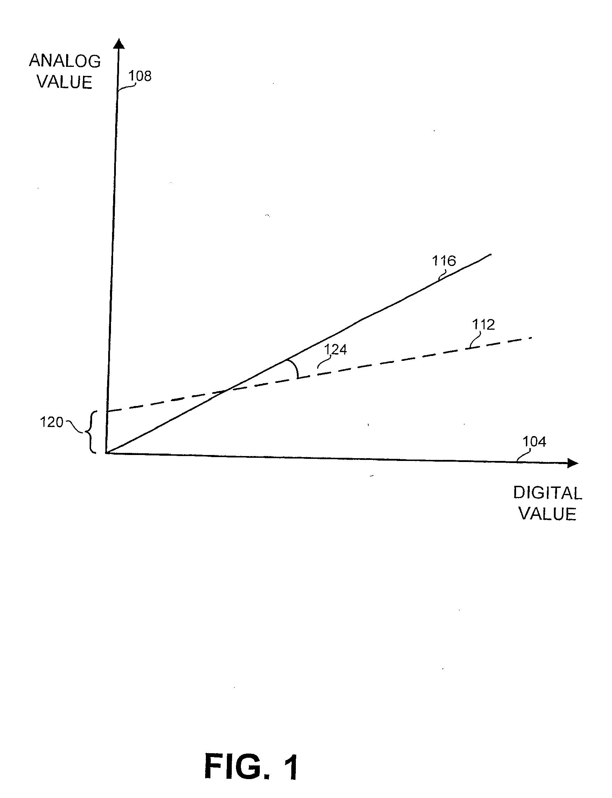

Consider for example Fig. 1, showing a graphical representation of two non-matching converters, in which horizontal axe 104 indicates the digital values, and vertical axe 108 indicates the analog values. Line 112 represents the transfer function of one converter, and line 116 represents the reverse transfer function of the other converter. Although both lines are shown on the same coordinate system it will be appreciated by person skilled in the art that for one converter axe 104 represents the input and axe 108 represents the output, and vice versa for the other converter. Since the two lines do not coincide, then there is an offset-value 120 and a gain-difference 124 between them. Once offset 120 and gain-difference 124 are known, they can be compensated for and the unit comprising the two converters can then be tested.

There is thus a need for a method and apparatus for detecting the offset and gain between a converter pair consisting of connected digital-to-analog converter DAC and an analog-to-digital converter, so that the unit as a whole can be tested for proper functionality, using digital equipment only.

In US patent No: 5,659,312 to Sunter et al. a method and apparatus for testing digital to analog and analog to digital converters is disclosed.

SUMMARY OF THE DISCLOSURE

A method and apparatus for testing a converter unit comprising a digital-to-analog converter and an analog-to-digital converter, without using analog testing equipment. An offset value and gain difference are determined for the two converters, the gain difference is fed to the digital-to-analog converter so as to enable digital control over the analog amplification of the unit.

In accordance with a preferred embodiment, there is thus provided a method for testing a unit comprising a first converter converting from digital to analog signals and a second converter converting from analog to digital signals, the method comprising: a calibration stage, the calibration stage comprising: an offset determination step for determining an offset between the first converter and the second converter; and a gain-difference determination step for determining a gain-control value differentiating between the first converter and the second converter; and a testing stage for testing the unit, wherein during the testing stage, the gain-control value is injected into the unit, and is used for changing the output of one of the first converter or the second converter, and wherein the offset is subtracted from the output of the second converter. Within the method, during the testing stage, a difference between a specific input value injected into the unit and an output value of the unit is optionally compared against a first threshold. Within the method, during the testing stage, an integrated difference between an input signal injected into the unit and a signal output by the unit is optionally compared against a second threshold. Within the method, the gain-difference determination step optionally uses successive approximation. Within the method, optionally the gain-difference value determined at each iteration of the successive approximation is used during later iterations. Optionally, the successive approximation determines a higher order bit of the gain value prior to determining a lower order bit. The method optionally comprises a step of sending a synchronization signal so as to adjust sampling an input signal injected into the unit with sampling an output signal output by the unit.

Another aspect of the disclosure relates to a testing apparatus for testing a unit having a unit amplification, the testing apparatus comprising a first converter converting from digital to analog signals and a second converter converting from analog to digital signals, the testing apparatus comprising: a signal generator for generating input signal to be injected into the unit; a test analyzer for comparing the input signal to an output signal output from the unit and determining an offset value and a gain-control value between the first converter and the second converter; and a test controller for controlling an offset value and test value determination stage and full testing stage, wherein after the offset value and the gain-control value are determined, the gain-control value is input into the unit, so as to enable digital control of the unit amplification. Within the apparatus, a synchronization signal is optionally sent from the signal generator to the test analyzer for matching a processing delay between the output signal and the input signal. Within the apparatus, the controller optionally controls test level durations so as to allow for a sampling rate higher for the output signal than for the input signal.

BRIEF DESCRIPTION OF THE DRAWINGS

Exemplary non-limited embodiments of the disclosed subject matter will be described, with reference to the following description of the embodiments, in conjunction with the figures. The figures are generally not shown to scale and any sizes are only meant to be exemplary and not necessarily limiting. Corresponding or like elements are designated by the same numerals or letters.

Fig. 1 is a schematic illustration of transfer functions of a DAC and ADC having an offset and a gain there between;
Fig. 2 is a schematic illustration of a testing apparatus, in a preferred embodiment of the disclosure;
Fig. 3 is a schematic flowchart of the main steps in the method for testing a converter unit, in accordance with a preferred embodiment of the disclosure;

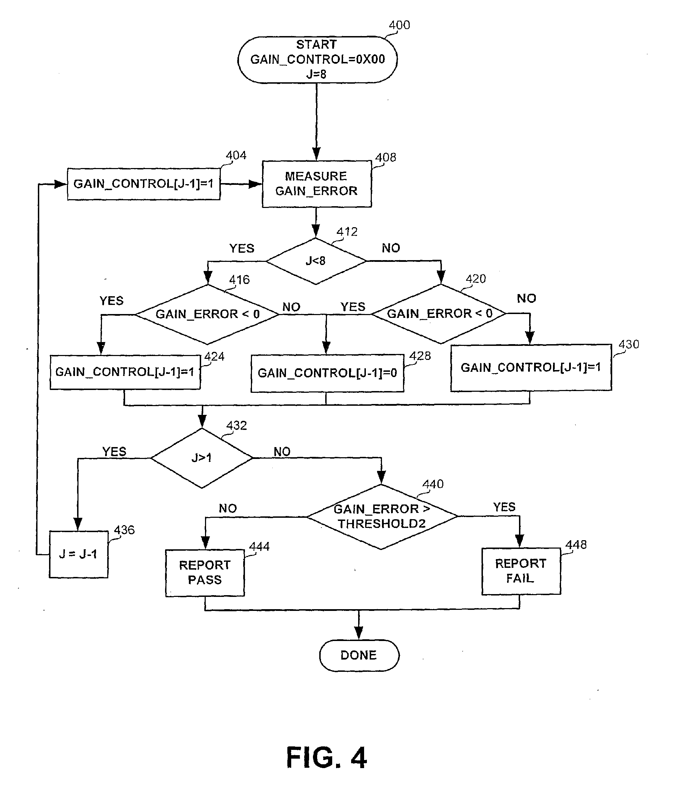

Fig. 4 is a schematic flowchart of the main steps in a method for gain calibration, in accordance with a preferred embodiment of the disclosure;
Fig. 5 is a schematic illustration of the signal generator, in accordance with a preferred embodiment of the disclosure; and
Fig. 6 is a schematic illustration of the signal test analyzer circuit, in accordance with a preferred embodiment of the disclosure.

DETAILED DESCRIPTION OF THE PREFERRED EMBODIMENT

In preferred embodiments of the disclosure, a testing environment is provided for testing a unit comprising a pair of DAC and an ADC. Testing comprises two main stages, a calibration stage in which the offset-value and the gain difference are determined, and a full testing stage at which the offset value and the gain difference are used when testing the unit with a wide voltage range. During calibration stage, the offset is determined first. A triangular symmetric wave is injected into the unit, preferably ranging between 0x100 and 0x300, with duration of a predetermined number of clock cycles for each voltage level, preferably between 2 and 17. The output of the unit is measured and averaged over all levels, and the reference (average) value of the triangular wave is subtracted from the averaged output. If the resulting difference is beyond a threshold level, the offset is too high and the unit is declared non-functional. Otherwise the offset-value is stored, and the gain-difference is determined, using the determined offset-value. The gain-difference is preferably determined by injecting a signal, preferably an almost full triangular wave, for example ranging between 0x010 and 0x3F0, so that as much of the input range is covered, but so that the output values will not be truncated. The gain-difference, i.e. the ratio between the peak-to-peak value of the DAC-input signal and the peak-to-peak value of the ADC-output signal is determined, by means of calculating the sum of differences between the absolute DAC-input and the absolute ADC-output signal, over a full cycle of the above mentioned triangular waveform, to generate a gain-difference error. If the resulting gain-difference error exceeds a second threshold value, the unit is declared non-functional.

Then, when the offset-value and gain-difference are available and their values are acceptable, the unit can be tested on substantially all values. When testing the unit, the DAC-output is multiplied by the gain-difference, thus cancelling the gain-difference, and the offset-value is subtracted from each input value. Thus, the transfer functions of the DAC and ADC are matched by neutralizing the gain error and testing the actual output vs. the input. value. Thus, the transfer functions of the DAC and ADC are matched by neutralizing the gain error and testing the actual output vs. the input.

Thus, using the offset-value and gain-difference during testing, provides the testing system with digital control over analog amplification, which enables the testing of the full range of values. Without such digital control, if the DAC amplification is to be increased or decreased by a factor, then digitization of the input multiplied by the gain factor will eliminate certain input values, resulting in incomplete testing. However, changing the gain enables the unit to be tested with all possible input values.

It will be appreciated by a person skilled in the art that although the disclosed methods and apparatus refer to a single channel, the same design can be applied to support two channels, a real channel and an imaginary channel.

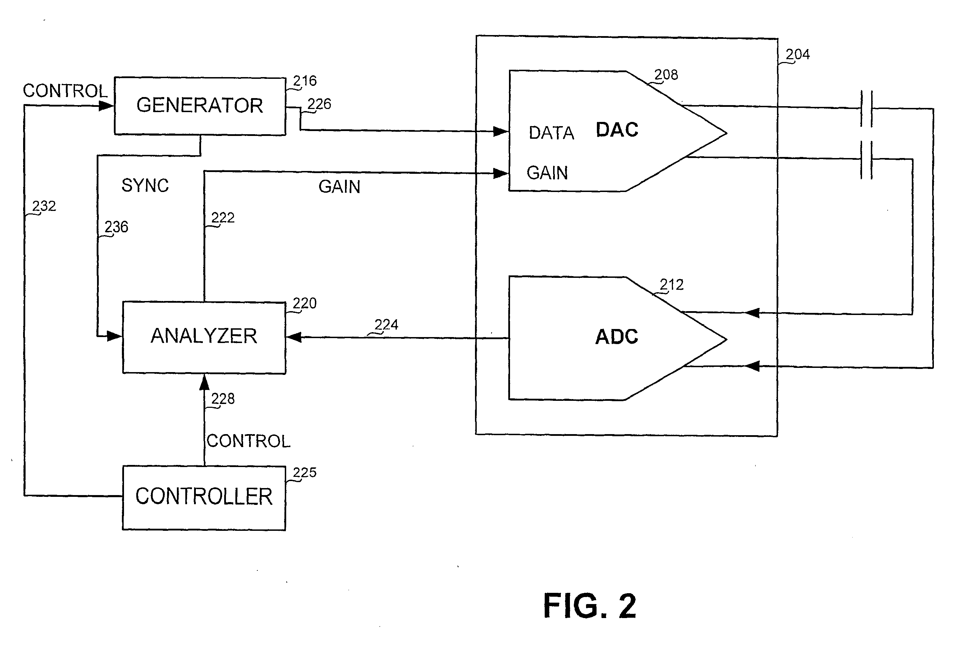

Referring now to Fig. 2, showing a schematic setting of a testing apparatus according to the disclosure. Unit 204 to be tested comprises DAC 208 and ADC 212. Signal generator 216 injects input signals 226 into unit 204, both at calibration stage and at full-testing stage. Analyzer 220 receives a synchronization signal 236 from generator 216, and output signal 224 of unit 204, and analyzes the results. Synchronization signal 236 is useful in matching the processing delay between the output stage and the input stage, so that the correct expected value is used.

During the calibration stage, a gain-difference value 222 is obtained, and then during the full testing stage, the gain difference is used as gain-control and is injected into DAC 208, so that output 224 can be directly compared to input 226. The offset value is used by the analyzer during analysis of the resulting voltage. Analyzer 220 thus performs the following functions: analysis of the testing patterns; determining the gain-difference and inputting the gain-control into the DAC; compensating the output signal using the offset value; controlling a test pattern generator to generate the proper test vectors; compensating for the pipeline delay between the DAC and ADC before comparing the values; supporting programmable tolerances for integrated nonlinearity and differential nonlinearity issuing the correct control signals, and for controlling test level durations so as to allow for a sampling rate higher for the output signal than for the input signal, due to the processing time difference between DAC 208 and ADC 212.

It will be appreciated by a person skilled in the art that gain 222 can alternatively be injected to and used by ADC 212 instead of DAC 208.

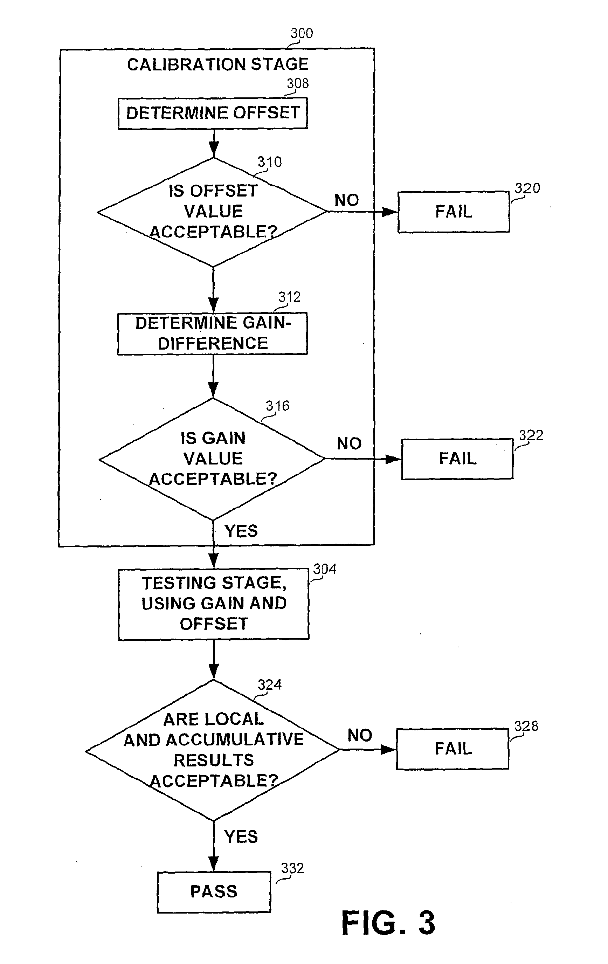

Referring now to Fig. 3, showing a flowchart of the main steps in testing a converter unit in accordance with the disclosure. The testing comprises two main stages, a calibration stage 300 and a testing stage 304, which uses the products of calibration stage 300, being the offset-value and the gain-difference. During the testing stage, the gain-control value is injected into the converter unit, and is used for changing the output of the DAC or the ADC.

Calibration stage 300 comprises offset-value determination step 308 for determining the offset between the DAC and the ADC, and gain-difference determination step 312 for determining the gain difference required to match between the DAC and the ADC. As detailed below, the offset-value is used during gain-determination, and temporary values of gain-difference are used for cancelling the gain-difference during later iterations of the gain-determination process.

Offset determination step 308 preferably comprises receiving a triangular wave, preferably having extreme values of 0x100 and 0x300 so that values exceeding these extremes will not be truncated, and M values altogether, wherein M is preferably 1024. The signal preferably has a duration of a predetermined number N, preferably ranging between 2 and 17) clock cycles for each voltage level, creating a frequency of 1/(2*N*T) wherein T is preferably but not limited to a 80MHz reference clock cycle time (12.5nsec). The ADC samples the received signal at the last cycle of each level for M cycles and the DC offset is determined according to the following formula:

$$Offset = \frac{1}{M} * \sum_{i=1}^{M} (ADC_{code[i]}) - reference$$

Wherein $ADC_{code[i]}$ is the output of the unit for input value i, and *reference* is the

$$Offset = \frac{1}{M} * \sum_{i=1}^{M} (ADC_{code[i]}) - reference$$

Wherein $ADC_{code[i]}$ is the output of the unit for input value i, and *reference* is the average value of the wave. This formula allows for averaging out the system noise from the DC offset value.

For offset calibration, the analyzer is fed with an offset value of 0 and with a reference value of 0. The accumulator is used to perform the integration function, while the offset value and the reference value are both set to 0x0. The division by M and the subtraction operations are done by the CPU software after accumulation is done. Once the offset value is determined, it is stored in an offset register.

Once offset determination step 308 is done, it is determined on step 310 whether the offset value exceeds a predetermined threshold, or is acceptable. If the value is not acceptable, the test is declared to fail on step 320. If the value is acceptable, gain determination step 312 is performed.

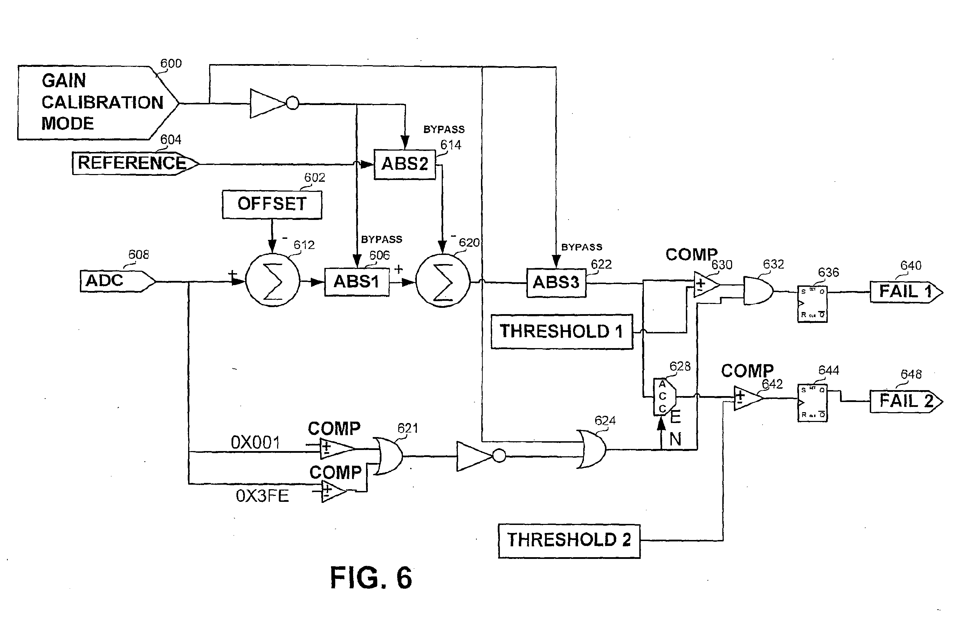

Gain determination step 312 and testing stage 304 are preferably performed by the same circuit, detailed in association with Fig. 6 below. During gain-difference determination step 312 a gain error is determined as detailed in association with Fig. 6 below. If the gain error exceeds a predetermined value, the unit is declared to fail on step 322.

If the offset and the gain-difference values are acceptable, on step 304 the unit will then be fully tested, wherein the test uses the determined offset and gain values. The offset-value is subtracted from the output of the ADC, and the gain-difference is used by setting the "unit size" of the DAC. In a preferred embodiment, the DAC generates output voltage which is proportional to the input. The ratio between the input and the output is controlled by the gain-control so as to compensate for the differences between the DAC gain and the ADC gain. The compensation assures that the DAC matches the ADC.

During the test, the difference between the input and output values is determined for each specific value, and the difference values are also integrated. If one or more specific value exceed a predetermined threshold-value, or the integrated value exceed another predetermined threshold-value, the unit is declared to fail on step 328, otherwise it is declared to pass on step 332.

Full test stage 304 can be implemented in a variety of ways. In one preferred embodiment, the testing is performed by a entering values generated by a pseudo random binary sequence (PRBS) generator, such as a linear feedback shift register, for example the register generated by the following formula: $D[9:0] = \{[Q8:Q0], \overline{Q9 \oplus Q6}\}$.

The PRBS is preferably initialized to 0x000. The PRBS generator scans 1023 codes of 10 bits value. The PRBS generator can be programmed to update its value every predetermined number of clock cycles. Since the DAC and the ADC may include some non-linear transformation functions, the ADC code may not match the DAC code. Therefore, a special logic is used to perform the following evaluation criteria:

> $Local\_Error = |DAC\_PRBS\_Value - ADC\_Sample\_Value|$
> $Local\_Error\_criteria = Sample\_Error > Threshold1$
> $Integrated\_Error\_Criteria = (\int local\_Error) > Threshold2$

If local_area_criteria or integrated_error_criteria are true, the testing failed.

Yet another embodiment for full test stage 304 related to monotonic testing, on which the DAC is driven by a counter value that scans substantially all the values from 0x000 to 0x3FF and down to 0x000, using one LSB step. Then the ADC output value is checked to track the injected signal and to assure monotonic transfer function, up to the allowed DNL limit.

The checking logic is preferably the same as detailed in association with the PRBS above.

It will be appreciated by a person skilled in the art that step 304 optionally comprises a step of sending a synchronization signal from the signal generator to the test analyzer for matching a processing delay between the output signal and the input signal, so that the correct expected value is used. is stored in a signed 8 bit value referred to as gain_control, and is determined using the successive approximation algorithm, starting at the highest order, i.e. the most significant bit (MSB) and working towards the lowest order, i.e. the least significant bit (LSB). When determining each bit of the gain, the gain accumulated so far is applied to the unit and is used for scaling the voltage, which enables determining the next bit.

The input voltage is preferably a nearly full-swing triangle signal, for example ranging between 0x010 and 0x3F0, with duration of N clock cycles for each level, N preferably ranging between 2 and 17, thus creating a frequency of 1/ (2*N*T) wherein T is preferably a 80MHz reference clock cycle time. The ADC preferably samples the received signal at the last cycle of each level and the test controller sets the gain calibration value according to the detailed algorithm.

On step 400 the method starts by assigning a value of zero to the gain_control, and setting an integer variable J to 8. On step 408 the gain error is measured, with the gain accumulated so far. The gain error is preferably determined according to the following formula:

$$Gain\_Error = \frac{1}{M}\sum_{1}^{M}(ABS(ADC - Offset) - ABS(reference))$$

Wherein M is preferably 2048-P, P being a number of cycles, for example 16, ignored at each end of the signal to avoid saturation effects.

On step 412, if J is smaller than 8, then if the gain error measured on step 408 is determined on step 416 to be negative, i.e. the output signal of the unit is smaller than the reference signal, then on step 424 the j-1 bit of gain_ control is set to one, otherwise on step 428 it is set to zero. If j=8, i.e. the MSB is handled, the reverse is done, since the gain_control is a signed number, and the initial value of zero implies mid-range value. Therefore, for j=8 if the gain_ error is determined in step 420 to be negative, the MSB bit of gain_control is set on step 428 to be 0, otherwise it is set on step 430 to be 1. On step 432, if J is larger than one, i.e. the LSB is not the currently updated bit, J is decremented by one, the value accumulated in gain_control is used as a gain fed to the unit, and the process returns to step 404. On step 404 bit [J-1] of gain_control is set to 1, and the process repeats for the next iteration. If J is equal to one, then it is determined in step 440 whether the gain_error, as measured after all bits were set exceeds a threshold. If the gain error exceeds the threshold, the unit is reported to fail on step 448, otherwise it is reported to pass, and the accumulated gain_control is used as the gain control value in testing stage 304 of Fig. 3. It will be appreciated that the method for determining the gain is exemplary only, and other methods can be designed for this purpose.

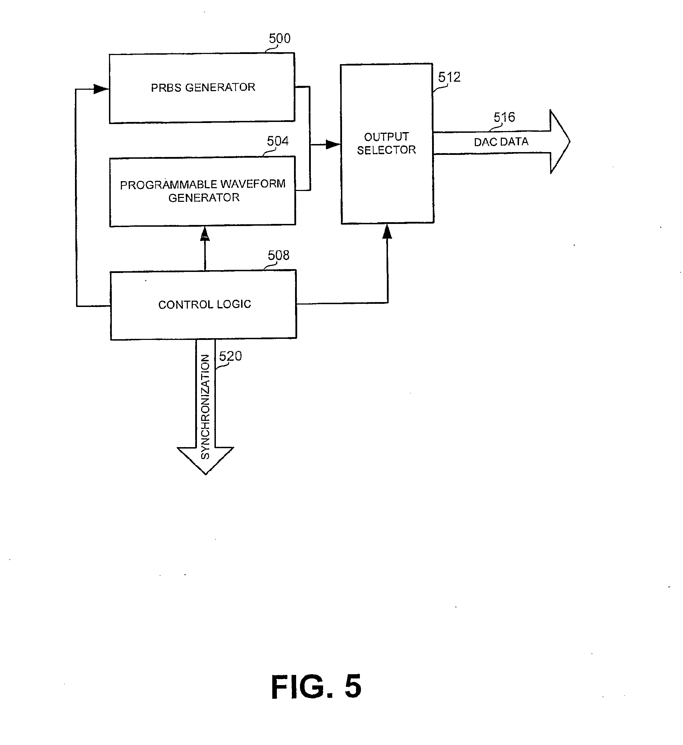

Referring now to Fig. 5, showing a schematic block diagram of the main components in a preferred implementation of signal generator 216 of Fig. 2. Signal generator 216 comprises a Pseudo random binary sequence generator 500, for generating signals of pseudo-randomly varying levels in order to test unit 204 under as realistic conditions as possible. Signal generator 216 further comprises programmable waveform generator 504 for generating any required wave, such as triangular waves having predetermined minimal and maximal values, and output selector 512 for selecting between the pseudo random signal and the wave signal and outputting data 516 to DAC 208 of Fig. 2. The selection uses the output of control logic unit 508, which sends synchronization signals 520 to analyzer 220 of Fig. 2.

Referring now to Fig. 6, showing a schematic diagram of the signal test analyzer circuit, which determines the gain and tests the converters unit.

The circuit uses two threshold values for the maximal allowed error, wherein the fist threshold is used in association with a specific sample maximal deviation, and the second threshold is used in association with a maximal deviation integrated over multiple values. The first threshold is preferably stored in a 16 bits read/write register, and the second threshold is preferably implemented as a 32 bit read/write register.

The accumulator is available for the CPU as a read-only 24 bits register. The accumulator is cleared to 0x0 at the start of each stage.

The accumulator is available for the CPU as a read-only 24 bits register. The accumulator is cleared to 0x0 at the start of each stage.

The circuit receives gain calibration mode 600, which is equal to one during gain-difference determination and calibration stage and zero during the testing stage; offset value 602 determined earlier; reference value 604, and ADC output 608.

For gain calibration measurements, ABS1 606 and ABS2 614 modules are enabled while ABS3 622 is bypassed. For the full testing, ABS1 606 and ABS2 614 are bypassed while ABS3 622 is enabled.

Logic gate 621 and logic gate 624 limit the value range during the full testing stage, but not during the calibration stage, to values less extreme than the full span of the signal, preferably between 0x001 and 0x3FE, so as to avoid the non linear effect of saturated input signal

Thus, during full testing stage, comparator 630 compares for each input value, the value of ABS(ADC-*offset-reference*) vs. Threshold1, and if the value exceeds Threshold1, a FAIL1 flag 640 is set and stored by flip-flop 636. Comparator 642 compares the values accumulated by accumulator 628 over the full period to threshold2, and if the accumulated value exceeds threshold2, a FAIL2 flag 648 is set and stored by flip-flop 644. During calibration stages, Fail1 flag 640 and Fail2 flag 648 are generally not used.

The disclosed methods and testing environment enable the determination of offset and gain-difference values between a DAC and ADC. The values are determined and then used when testing the output value of a pair of converters, so as to avoid testing them separately, thus saving on excessive equipment and time. Injecting the gain into any of the converters enable digital control over the analog amplification, which enables testing the full range of input values.

The methods and testing environment are preferably used as a built-in self test that can accelerate the testing time and reduce costs, assure robust and repeatable test coverage. When a system is composed from only one DAC which has gain calibration option and more than one ADC channels, the different ADC performed sequentially. On the first stage the DACs will be used to validate the ADC of the first ADC channel, and once completed, the test will be repeated with the ADCs of the next ADC channel and so on until all the channels are tested.

It will be appreciated that in order to match the differences in processing time between the DAC and the ADC, wherein the DAC is generally faster, either the value injected into the DAC is maintained by generator 216 of Fig. 2 according to control signals sent from the controller to the signal generator, so that the value can then be compared against the output, or analyzer 220 is equipped with a mechanism for storing the value input into the DAC until the relevant output value can be measured.

It will be appreciated by a person skilled in the art that the coupling capacitors connecting the DAC output to the ADC input require charging to allow for accurate measurement to take place. However, as described below, for charging the coupling capacitors, the DAC will have to feed a pattern that will be used only for setup capacitors charging. As the feedback from the DAC to the ADC is performed in AC coupled circuit, the BIST logic will perform the pattern injection for a full cycle before the actual sampling starts. As an example, during the offset calibration, the generator will first inject full cycle of the test pattern, and only on the following cycle the measurement will be performed. During the coupling capacitors charging phase, all the calibration and measurements status registers (including the error detections and the accumulators) are frozen in reset state. The coupling capacitors charging may be skipped according to special configuration bit.

It will also be appreciated by a person skilled in the art that multiple variations and options can be designed along the guidelines of the disclosed method and apparatus. Such variations are covered by the disclosure.

While the disclosure has been described with reference to exemplary embodiments, it will be understood by those skilled in the art that various changes may be made and equivalents may be substituted for elements thereof without departing from the scope of the disclosure. In addition, many modifications may be made to adapt a particular situation, material, step of component to the teachings without departing from the essential scope thereof. Therefore, it is intended that the disclosed subject matter not be limited to the particular embodiment disclosed as the best mode contemplated for carrying out this invention, but only by the claims that follow.

**Claims**

1. A method for testing a unit (204) comprising a first converter (208) converting from digital to analog signals and a second converter (212) converting from analog to digital signals, the method comprising:

   calibrating (300) the unit (204) by:

      injecting a first input signal (226) into the unit (204), wherein the first input signal (226) has a first range of values provided as a digital sequence of bits,
      determining an offset (308) that is an average of the differences between the range of values of the input signal (226) and a range of values of a first output signal (224) output from the unit (204), and
      determining a gain-difference (312) between the range of values of the input signal (226) and the range of values of the first output signal (224); and

   testing (304) the unit (204), after determining the offset and the gain difference, by:

      injecting a second input signal (226) into the unit (204), wherein the second input signal (226) has a second range of values provided as a digital sequence of bits,
      subtracting the offset from a range of values of a second output signal (224) output from the unit (204) to obtain a compensated second output signal,
      determining the difference between the range of values of the second input signal (226) and the range of values of the compensated second output signal,
      comparing the difference to a predetermined threshold value to determine if the unit functions correctly; and

      **characterized by** injecting the gain-difference into the unit (204) during the testing for use with one of the first converter (208) or the second converter (212) to cancel the gain difference between the first converter (208) and the second converter (212).

2. The method of claim 1, wherein the full range of values accepted by the first converter (208) is used as the second range of values during the testing (304).

3. The method of claim 1, wherein during the testing (304), an integrated difference between a range of values of an input signal (226) injected into the unit (204) and a range of values of an output signal (224) output by the unit (204) is compared against a second threshold.

4. The method of claim 1 wherein the gain-difference determination uses successive approximations.

5. The method of claim 4 wherein the gain-difference value determined at each iteration of the successive approximations is used during later iterations.

6. The method of claim 4 wherein the successive approximation determines a higher order bit of the gain value prior to determining a lower order bit.

7. The method of claim 1 further comprising a step of sending a synchronization signal (236) so as to adjust sampling the input signal (226) injected into the unit with sampling an output signal (224) output by the unit (204).

8. A testing apparatus for testing a unit (204) having a unit amplification, the testing apparatus comprising a first converter (208) converting from digital to analog signals and a second converter (212) converting from analog to digital signals, the testing apparatus comprising:

a signal generator (216) for generating an input signal (226) to be injected into the unit (204), wherein the input signal (226) has a range of values provided as a digital sequence of bits;
a test analyzer (220) for comparing the input signal (226) to an output signal (224) output from the unit (204) and determining an offset and a gain-difference between the range of values of the input signal (226) and a range of values of an output signal output from the unit (204);
a test controller (225) for controlling an offset and gain-difference determination step and a full unit testing step; and

**characterized in that**, after the offset and the gain-difference are determined, the gain-difference is input into the unit (204) during the full unit testing step for use with one of the first converter (208) or the second converter (212) to cancel the gain difference between the first converter (208) and the second converter (212), so as to enable digital control of the unit amplification.

9. The apparatus of claim 8 wherein a synchronization signal (236) is sent from the signal generator (216) to the test analyzer (220) for matching a processing delay between the output signal (224) and the input signal (226).

10. The apparatus of claim 8 wherein the test controller (225) controls test level durations so as to allow for a sampling rate higher for the output signal (224) than for the input signal (226).

**Patentansprüche**

1. Verfahren zum Testen einer Einheit (204), die einen ersten Umsetzer (208), der von einem digitalen in ein analoges Signal umsetzt, und einen zweiten Umsetzer (212), der von einem analogen in ein digitales Signal umsetzt, umfasst, wobei das Verfahren umfasst:

Kalibrieren (300) der Einheit (204) durch:

Einspeisen eines ersten Eingangssignals (226) in die Einheit (204), wobei das erste Eingangssignal (226) einen ersten Bereich von Werten aufweist, die als eine digitale Bitfolge bereitgestellt werden,
Bestimmen eines Versatzes (308), der ein Durchschnitt der Differenzen zwischen dem Bereich von Werten des Eingangssignals (226) und einem Bereich von Werten eines von der Einheit (204) ausgegebenen ersten Ausgangssignals (224) ist, und
Bestimmen einer Verstärkungsdifferenz (312) zwischen dem Bereich von Werten des Eingangssignals (226) und dem Bereich von Werten des ersten Ausgangssignals (224); und

Testen (304) der Einheit (204) nach der Bestimmung des Versatzes und der Verstärkungsdifferenz durch:

Einspeisen eines zweiten Eingangssignals (226) in die Einheit (204), wobei das zweite Eingangssignal (226) einen zweiten Bereich von Werten aufweist, die als eine digitale Bitfolge bereitgestellt werden,
Subtrahieren des Versatzes von einem Bereich von Werten eines von der Einheit (204) ausgegebenen zweiten Ausgangssignals (224), um ein kompensiertes zweites Ausgangssignal zu erhalten,
Bestimmen der Differenz zwischen dem Bereich von Werten des zweiten Eingangssignals (226) und dem Bereich von Werten des kompensierten zweiten Ausgangssignals,
Vergleichen der Differenz mit einem vorgegebenen Schwellenwert, um zu bestimmen, ob die Einheit richtig arbeitet; und

**gekennzeichnet durch** das Einspeisen der Verstärkungsdifferenz in die Einheit (204) während des Testens zur Verwendung mit dem ersten Umsetzer (208) oder mit dem zweiten Umsetzer (212), um die Verstärkungsdifferenz zwischen dem ersten Umsetzer (208) und dem zweiten Umsetzer (212) auszugleichen.

2. Verfahren nach Anspruch 1, wobei der volle Bereich von Werten, die von dem ersten Umsetzer (208) angenommen werden, während des Testens (304) als der zweite Bereich von Werten verwendet wird.

3. Verfahren nach Anspruch 1, wobei während des Testens (304) eine integrierte Differenz zwischen einem Bereich von Werten eines in die Einheit (204) eingespeisten Eingangssignals (226) und einem Bereich von Werten eines durch die Einheit (204) ausgegebenen Ausgangssignals (224) mit einem zweiten Schwellenwert verglichen wird.

4. Verfahren nach Anspruch 1, wobei die Bestimmung der Verstärkungsdifferenz sukzessive Approximationen verwendet.

5. Verfahren nach Anspruch 4, wobei der bei jeder Iteration der sukzessiven Approximationen bestimmte Verstärkungsdifferenzwert während späterer Iterationen verwendet wird.

6. Verfahren nach Anspruch 4, wobei die sukzessive Approximation ein Bit höherer Ordnung des Verstärkungswerts vor der Bestimmung eines Bits niedrigerer Ordnung bestimmt.

7. Verfahren nach Anspruch 1, das ferner einen Schritt des Sendens eines Synchronisationssignals (236), um die Abtastung des in die Einheit eingespeisten Eingangssignals (226) mit der Abtastung eines durch die Einheit (204) ausgegebenen Ausgangssignals (224) abzustimmen, umfasst.

8. Testvorrichtung zum Testen einer Einheit (204), die eine Verstärkung der Einheit aufweist, wobei die Testvorrichtung einen ersten Umsetzer (208), der von einem digitalen in ein analoges Signal umsetzt, und einen zweiten Umsetzer (212), der von einem analogen in ein digitales Signal umsetzt, umfasst, wobei die Testvorrichtung umfasst:

einen Signalgenerator (216) zum Erzeugen eines Eingangssignals (226), das in die Einheit (204) eingespeist werden soll, wobei das Eingangssignal (226) einen Bereich von Werten, die als eine digitale Bitfolge bereitgestellt werden, aufweist;
einen Testanalysator (220) zum Vergleichen des Eingangssignals (226) mit einem von der Einheit (204) ausgegebenen Ausgangssignal (224) und zum Bestimmen eines Versatzes und einer Verstärkungsdifferenz zwischen dem Bereich von Werten des Eingangssignals (226) und einem Bereich von Werten eines von der Einheit (204) ausgegebenen Ausgangssignals;
einen Testcontroller (225) zum Steuern eines Schritts der Bestimmung eines Versatzes und einer Verstärkungsdifferenz und eines Schritts des vollen Tests der Einheit; und

**dadurch gekennzeichnet, dass**, nachdem der Versatz und die Verstärkungsdifferenz bestimmt worden sind, die Verstärkungsdifferenz während des Schritts des vollen Tests der Einheit zur Verwendung mit dem ersten Umsetzer (208) oder mit dem zweiten Umsetzer (212) in die Einheit (204) eingegeben wird, um die Verstärkungsdifferenz zwischen dem ersten Umsetzer (208) und dem zweiten Umsetzer (212) auszugleichen, um so die digitale Steuerung der Verstärkung der Einheit zu ermöglichen.

9. Vorrichtung nach Anspruch 8, wobei ein Synchronisationssignal (236) von dem Signalgenerator (216) an den Testanalysator (220) gesendet wird, um eine Verarbeitungsverzögerung zwischen dem Ausgangssignal (224) und dem Eingangssignal (226) anzugleichen.

10. Vorrichtung nach Anspruch 8, wobei der Testcontroller (225) Testpegeldauern in der Weise steuert, dass für das Ausgangssignal (224) eine höhere Abtastrate als für das Eingangssignal (226) ermöglicht wird.

**Revendications**

1. Méthode pour tester une unité (204) comprenant un premier convertisseur (208) convertissant des signaux numériques en signaux analogiques et un second convertisseur (212) convertissant des signaux analogiques en signaux numériques, la méthode comprenant :

l'étalonnage (300) de l'unité (204) par :

l'injection d'un premier signal d'entrée (226) dans l'unité (204), dans laquelle le premier signal d'entrée (226) a une première plage de valeurs fournies en tant qu'une séquence numérique de bits,
la détermination d'un décalage (308) qui est une moyenne des différences entre la plage de valeurs du signal d'entrée (226) et une plage de valeurs d'un premier signal de sortie (224) délivré à partir de l'unité (204), et
la détermination d'une différence de gain (312) entre la plage de valeurs du signal d'entrée (226) et la plage de valeurs du premier signal de sortie (224) ; et

le test (304) de l'unité (204), après la détermination du décalage et de la différence de gain, par :

l'injection d'un second signal d'entrée (226) dans l'unité (204), dans laquelle le second signal d'entrée (226) a une seconde plage de valeurs fournies en tant qu'une séquence numérique de bits,
la soustraction du décalage à une plage de valeurs d'un second signal de sortie (224) délivré à partir de l'unité (204) pour obtenir un second signal de sortie compensé,
la détermination de la différence entre la plage de valeurs du second signal d'entrée (226) et la plage de valeurs du second signal de sortie compensé,
la comparaison de la différence à une valeur de seuil prédéterminée pour déterminer si l'unité fonctionne correctement ; et

**caractérisée par** l'injection de la différence de gain dans l'unité (204) au cours du test pour l'utiliser avec l'un du premier convertisseur (208) ou du second convertisseur (212) pour annuler la différence de gain entre le premier convertisseur (208) et le second convertisseur (212).

2. Méthode de la revendication 1, dans laquelle la plage complète de valeurs acceptées par le premier convertisseur (208) est utilisée en tant que la seconde plage de valeurs au cours du test (304).

3. Méthode de la revendication 1, dans laquelle, au cours du test (304), une différence intégrée entre une plage de valeurs d'un signal d'entrée (226) injecté dans l'unité (204) et une plage de valeurs d'un signal de sortie (224) délivré par l'unité (204) est comparée à un second seuil.

4. Méthode de la revendication 1, dans laquelle la détermination de différence de gain utilise des approximations successives.

5. Méthode de la revendication 4, dans laquelle la valeur de différence de gain déterminée à chaque itération des approximations successives est utilisée au cours d'itérations ultérieures.

6. Méthode de la revendication 4, dans laquelle l'approximation successive détermine un bit d'ordre supérieur de la valeur de gain avant la détermination d'un bit d'ordre inférieur.

7. Méthode de la revendication 1, comprenant en outre une étape d'envoi d'un signal de synchronisation (236) de manière à ajuster l'échantillonnage du signal d'entrée (226) injecté dans l'unité avec l'échantillonnage d'un signal de sortie (224) délivré par l'unité (204).

8. Appareil de test pour tester une unité (204) ayant une amplification d'unité, l'appareil de test comprenant un premier convertisseur (208) convertissant des signaux numériques en signaux analogiques et un second convertisseur (212) convertissant des signaux analogiques en signaux numériques, l'appareil de test comprenant :

un générateur de signal (216) pour générer un signal d'entrée (226) à injecter dans l'unité (204), dans lequel le signal d'entrée (226) a une plage de valeurs fournies en tant qu'une séquence numérique de bits ;
un analyseur de test (220) pour comparer le signal d'entrée (226) à un signal de sortie (224) délivré à partir de l'unité (204) et pour déterminer un décalage et une différence de gain entre la plage de valeurs du signal d'entrée (226) et une plage de valeurs d'un signal de sortie délivré à partir de l'unité (204) ;
un contrôleur de test (225) pour contrôler une étape de détermination de décalage et de différence de gain et une étape de test d'unité complète ; et
**caractérisé en ce que**, après la détermination du décalage et de la différence de gain, la différence de gain est entrée dans l'unité (204) au cours de l'étape de test d'unité complète pour être utilisée avec l'un du premier convertisseur (208) ou du second convertisseur (212) pour annuler la différence de gain entre le premier convertisseur (208) et le second convertisseur (212), de manière à permettre un contrôle numérique de l'amplification d'unité.

9. Appareil de la revendication 8, dans lequel un signal de synchronisation (236) est envoyé à partir du générateur de signal (216) à l'analyseur de test (220) pour correspondre à un retard de traitement entre le signal de sortie (224) et le signal d'entrée (226).

10. Appareil de la revendication 8, dans lequel le contrôleur de test (225) contrôle des durées de niveau de test afin de permettre une fréquence d'échantillonnage pour le signal de sortie (224) supérieure à celle pour le signal d'entrée (226).

**FIG. 1**

**FIG. 2**

EP 2 235 833 B1

**FIG. 3**

**FIG. 4**

**FIG. 5**

**FIG. 6**

**EP 2 235 833 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5659312 A, Sunter